Europäisches Patentamt

European Patent Office

Office européen des brevets

(19)

(11) Numéro de publication: **0 209 425**
**B1**

(12) **FASCICULE DE BREVET EUROPEEN**

(45) Date de publication du fascicule du brevet:
**23.05.90**

(21) Numéro de dépôt: **86401299.2**

(22) Date de dépôt: **16.06.86**

(51) Int. Cl.⁵: **H01L 21/28,** H01L 29/60,
H01L 29/78

(54) Procédé de réalisation d'un dispositif semiconducteur à plusieurs niveaux de grilles.

(30) Priorité: **18.06.85 FR 8509242**

(43) Date de publication de la demande:
**21.01.87 Bulletin 87/4**

(45) Mention de la délivrance du brevet:
**23.05.90 Bulletin 90/21**

(84) Etats contractants désignés:
**DE GB NL**

(56) Documents cités:
**EP-A- 0 026 376**
**EP-A- 0 099 603**
**US-A- 3 943 543**
**US-A- 4 055 885**
**US-A- 4 141 024**

**IBM TECHNICAL DISCLOSURE BULLETIN,**
**vol. 21, no. 5, octobre 1978, pages 1865-1866, New York,**
**US; R. GDULA et al.: "CCD with levels of polysilicon"**

(73) Titulaire: **THOMSON-CSF, 51, Esplanade du Général de Gaulle, F-92800 Puteaux(FR)**

(72) Inventeur: **Blanchard, Pierre, THOMSON-CSF SCPI 19, avenue de Messine, F-75008 Paris(FR)**
Inventeur: **Cortot, Jean-Paul, THOMSON-CSF SCPI 19, avenue de Messine, F-75008 Paris(FR)**

(74) Mandataire: **Mayeux, Michèle et al, THOMSON-CSF SCPI, F-92045 PARIS LA DEFENSE CEDEX 67(FR)**

## Description

La présente invention concerne un procédé de réalisation d'un dispositif semi-conducteur à plusieurs niveaux de grilles.

L'invention peut être utilisée en particulier pour réaliser des dispositifs à transfert de charge et dans la description suivante, on évoquera de préférence ce domaine. L'invention peut cependant être utilisée pour réaliser tout dispositif semi-conducteur comportant plusieurs niveaux de grilles, tel que par exemple une zone photosensible constituée de transistors MOS.

On rappelle qu'il est d'usage courant dans ce domaine de désigner par l'expression "plusieurs niveaux de grilles", des grilles coplanaires mais qui ne sont pas réalisées simultanément. Ainsi, il est possible de traiter différemment le substrat semi-conducteur situé sous ces différentes grilles. Par exemple, dans le cas des dispositifs à transfert de charge, pour réaliser un dispositif avec deux niveaux de grilles, dans lequel la dissymétrie dans les potentiels de canal nécessaire pour rendre unilatéral le transfert est réalisée par implantation ionique, il faut doper le substrat situé sous les grilles du premier niveau, réaliser ces grilles puis doper différemment le substrat situé sous les grilles du second niveau et réaliser ces grilles.

On connaît dans l'art antérieur des dispositifs à transfert de charge, à plusieurs niveaux de grilles, avec dissymétrie par implantation ionique.

L'inconvénient des technologies actuelles courantes est qu'elles conduisent à des dispositifs dans lesquels il y a un recouvrement relativement important des grilles du niveau technologique supérieur sur celles du niveau sous-jacent.

Ce recouvrement introduit un couplage capacitif non négligeable entre grilles, qui perturbe le fonctionnement du dispositif.

De plus, ce couplage peut être différent d'un dispositif à l'autre ce qui est gênant en particulier dans les dispositifs à structure biphasée où l'on relie deux électrodes de deux niveaux différents. Les capacités parasites n'étant pas identiques, les divers couples d'électrodes présentent des temps d'accès différents et peuvent nécessiter des signaux d'horloge adaptés selon les dispositifs.

De plus, ce recouvrement introduit un relief qui est gênant si l'on cherche à obtenir une intégration maximum.

La présente invention concerne un procédé de réalisation d'un dispositif semi-conducteur à au moins deux niveaux de grilles, caractérisé en ce qu'il comporte les étapes telles que revendiquées.

Le procédé selon l'invention présente l'avantage de ne recourir qu'à des technologies standards. De plus, il peut être appliqué quel que soit le relief du substrat utilisé, et en particulier qu'il soit planarisé ou non.

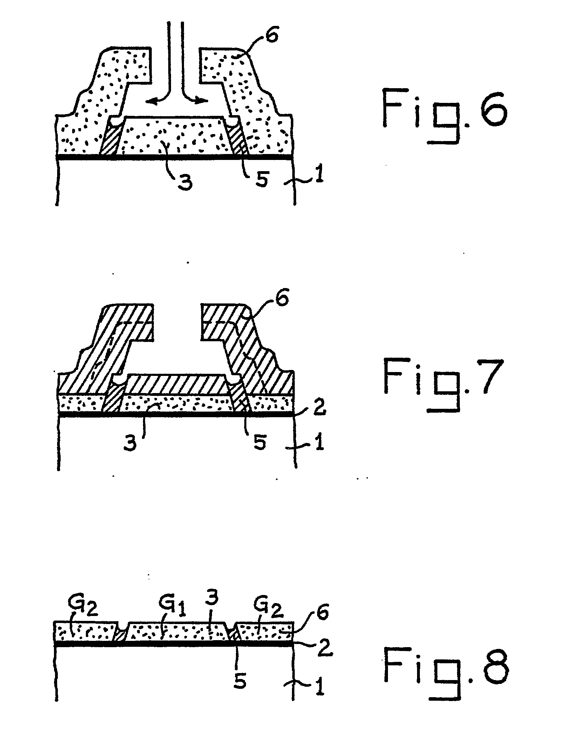

Le procédé selon l'invention permet la réalisation d'un dispositif semi-conducteur à plusieurs niveaux de grilles, tel que par exemple celui représenté sur la figure 8, qui présente les avantages suivants :
- le recouvrement entre les grilles des divers niveaux est constant et limité à la pente des côtés des grilles du niveau inférieur. Ce recouvrement est donc uniquement latéral et introduit des capacités parasites de bien plus faibles valeurs que celles existant dans les dispositifs de l'art antérieur. Ainsi, par exemple, on obtient un recouvrement latéral de 0,35 µm alors que dans l'art antérieur le recouvrement est couramment de 1,5 µm;
- l'efficacité de transfert est maximum ;
- enfin, le dispositif est planarisé comme on le voit sur la figure 8.

On connaît une technologie récente qui permet d'aboutir à une structure voisine de celle de la figure 8. Cette technologie, couramment appelée "RIE, reaction etching" s'appuie sur une technique de gravure. Sa mise en oeuvre est délicate et elle donne des résultats pas toujours très satisfaisants. De plus, il est nécessaire que le substrat sur lequel sont réalisées les grilles soit planarisé.

Le procédé selon l'invention présente donc par rapport à la technologie "RIE" des avantages de simplicité, d'efficacité et aussi l'avantage de pouvoir être utilisé sur un substrat planarisé ou non.

Le brevet US 4 055 885 décrit un procédé pour obtenir des grilles non recouvrantes sur plusieurs niveaux; il utilise une technique de lift-off, avec dépôt directif de métal par évaporation; il n'est pas applicable à des grilles en silicium polycristallin.

D'autres objets, caractéristiques et résultats de l'invention ressortiront de la description suivante, donnée à titre d'exemple non limitatif et illustrée par les figures annexées qui représentent:

– les figures 1 à 8, différentes étapes du procédé selon l'invention dans le cas de la réalisation d'un dispositif semi-conducteur à deux niveaux de grilles;

– les figures 9 et 10, des étapes complémentaires dans le cas de la réalisation d'un dispositif semi-conducteur à trois niveaux de grilles.

Sur les différentes figures, les mêmes repères désignent les mêmes éléments, mais, pour des raisons de clarté, les cotes et proportions des divers éléments ne sont pas respectées.

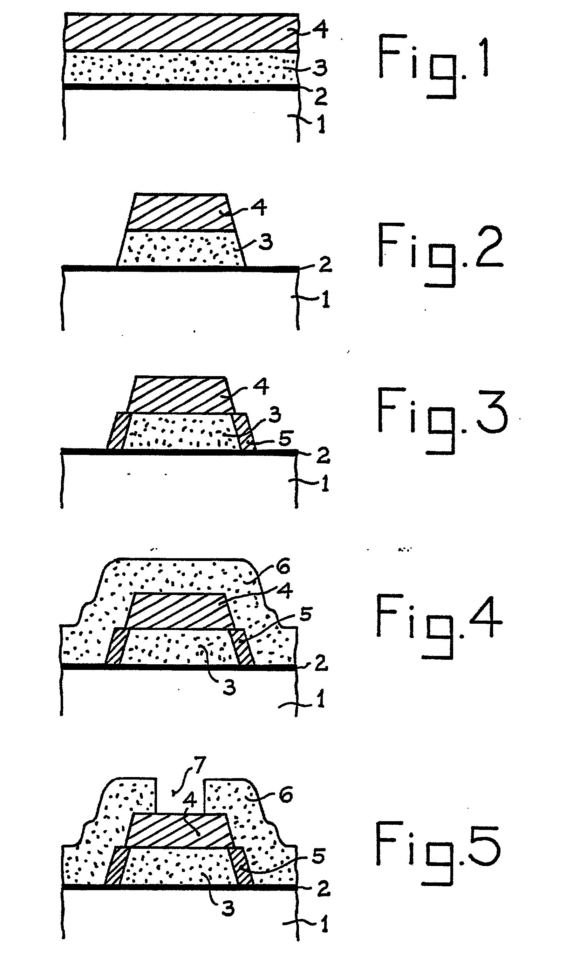

Les figures 1 à 8 représentent différentes étapes du procédé selon l'invention, dans le cas de la réalisation d'un dispositif semi-conducteur à deux niveaux de grilles, où le premier niveau est réalisé sur une couche de diélectrique.

Sur la figure 1, on a représenté le substrat semi-conducteur 1, recouvert d'une couche de diélectrique 2, puis d'une couche de matériau 3 dans lequel doivent être réalisées les grilles du premier niveau et d'une autre couche de diélectrique 4.

Le substrat semi-conducteur 1 peut être en silicium monocristallin. Il peut aussi s'agir de la couche de silicium d'une structure SOS, ou de tout autre semi-conducteur.

La couche de diélectrique 2 peut être constituée d'une ou plusieurs couches de diélectriques. Par exemple, cette couche peut être constituée de silice ou de nitrure ou de silice recouverte de nitrure...

La couche de matériau 3 dans lequel doivent être réalisées les grilles du premier niveau peut être en silicium polycristallin ou en silicium polycristallin recouvert de siliciure, par exemple. Si le dispositif à réaliser n'est pas un dispositif à transfert de charge cette couche 3 peut être métallique, en aluminium par exemple.

La couche de diélectrique 4 est par exemple une couche d'oxyde, de la silice par exemple. Cette couche d'oxyde peut être obtenue par croissance d'oxyde ou par dépôt, pyrolytique par exemple.

Lorsque la couche 3 est métallique, on réalise un dépôt d'oxyde 4 à basse température, par exemple un dépôt pyrolytique ou un dépôt par plasma.

Sur la figure 2, on montre que par photo-lithogravure on grave les couches 3 et 4.

L'inclinaison des flancs des grilles du premier niveau ainsi obtenues déterminera le recouvrement final entre grilles du premier et du second niveau.

L'étape illustrée par la figure 3 consiste à isoler les flancs des grilles du premier niveau réalisées.

Cela peut se faire par exemple par croissance d'oxyde 5 comme cela est représenté sur la figure 3.

Cela peut aussi se faire par exemple par dépôt d'une couche d'oxyde, par voie pyrolytique par exemple.

Sur la figure 4, on montre qu'on dépose une autre couche 6 de matériau dans lequel doivent être réalisées les grilles du second niveau. Cette couche peut être différente de celle utilisée pour réaliser les grilles du premier niveau.

Sur la figure 5, on montre qu'on réalise dans cette couche 6 une ouverture 7 permettant d'accéder à la couche d'oxyde 4 recouvrant le dessus des grilles du premier niveau.

Cette ouverture peut être par exemple réalisée par photogravure ou par gravure chimique selon la nature de la couche 6.

Il n'est pas nécessaire que les ouvertures 7 soient très bien centrées par rapport aux grilles du premier niveau, car le positionnement de cette ouverture ne conditionne pas l'uniformité du recouvrement entre grilles des divers niveaux. Comme on va le voir dans la description des figures suivantes, cette ouverture a pour rôle de permettre l'accès à la couche 4 pour la supprimer et de permettre l'attaque par ses deux faces de la couche 6. Le positionnement de l'ouverture 7 n'est donc pas critique.

Sur la figure 6, on retire la couche 4 de façon à mettre à nu le dessus de la grille 3.

Lorsque la couche 4 est constituée d'un oxyde, on peut la supprimer par attaque chimique avec de l'acide fluorhydrique par exemple.

La vitesse de cette attaque peut être très bien contrôlée ce qui permet de conserver les couches d'oxyde 5 qui assureront l'isolement entre grilles des divers niveaux.

L'étape suivante du procédé consiste à supprimer les parties de la couche 6 qui surplombent les grilles 3 du premier niveau.

Cette étape peut se faire :
- soit par gravure plasma ;
- soit par gravure chimique.

Si l'on choisit de procéder par gravure plasma, on utilise un gaz qui attaque la couche 6 en silicium polycristallin par exemple.

On détermine le temps d'action du gaz de façon à ce qu'il agisse sensiblement sur la moitié de l'épaisseur de la couche 6. Comme la couche 6 est soumise par ses deux faces à l'action de ce gaz dans ses parties surplombant la couche 3, on arrive ainsi à la supprimer totalement dans ces parties et à en supprimer environ la moitié dans ses parties horizontales.

Sur la figure 7 on a hachuré les zones de la couche 6 qui seront éliminées.

Le résultat de la gravure par plasma est représenté sur la figure 8. La partie des grilles du deuxième niveau 6 qui surplombe les grilles du premier niveau est supprimée. Les grilles du premier et du deuxième niveau, 3 et 6, ont leur épaisseur réduite sensiblement de moitié par rapport à l'étape de la figure 6.

Le recouvrement entre les grilles du premier et du deuxième niveau, que l'on appelle aussi $G_1$ et $G_2$, est donc limité à l'inclinaison du pourtour des grilles $G_1$ qui dépend de la gravure illustrée par la figure 2.

Les deux niveaux de grilles sont isolés par la couche 5 dont l'épaisseur dépend de l'étape illustrée par la figure 3.

On constate que le dispositif obtenu sur la figure 8 est parfaitement planarisé.

On n'a pas représenté sur les figures 1 à 8 les opérations d'implantation ionique nécessaires pour réaliser un dispositif à transfert de charge et qui sont indépendantes du procédé de réalisation de plusieurs niveaux de grilles.

Sur la figure 7, on a illustré comment on peut supprimer les zones de la couche 6 qui surplombent les grilles du premier niveau par gravure chimique.

Lorsque la grille 6 est en silicium polycristallin, cette gravure chimique est réalisée après oxydation de la grille.

On règle la durée de l'oxydation pour que la moitié de l'épaisseur de la grille 6 soit oxydée.

Sur la figure 7, on a symbolisé par des hachures l'oxydation d'environ la moitié de l'épaisseur des grilles 3, des parties planes des grilles 6 et de la totalité des parties en surplomb des grilles 6, puisque ces parties sont oxydées par leurs faces interne et externe simultanément.

Une désoxydation permet de supprimer les zones hachurées et d'obtenir la structure représentée sur la figure 8.

Lorsque les grilles 6 sont métalliques, on utilise une gravure chimique qui n'implique pas nécessairement une étape d'oxydation préalable.

Il est possible de protéger les grilles $G_1$ du premier niveau des étapes représentées sur les figures 6 à 8 en interposant une couche protectrice contre la gravure par plasma ou la gravure chimique entre chaque grille $G_1$ et la couche 4. On peut utiliser par exemple une couche de nitrure de silicium $Si_3N_4$.

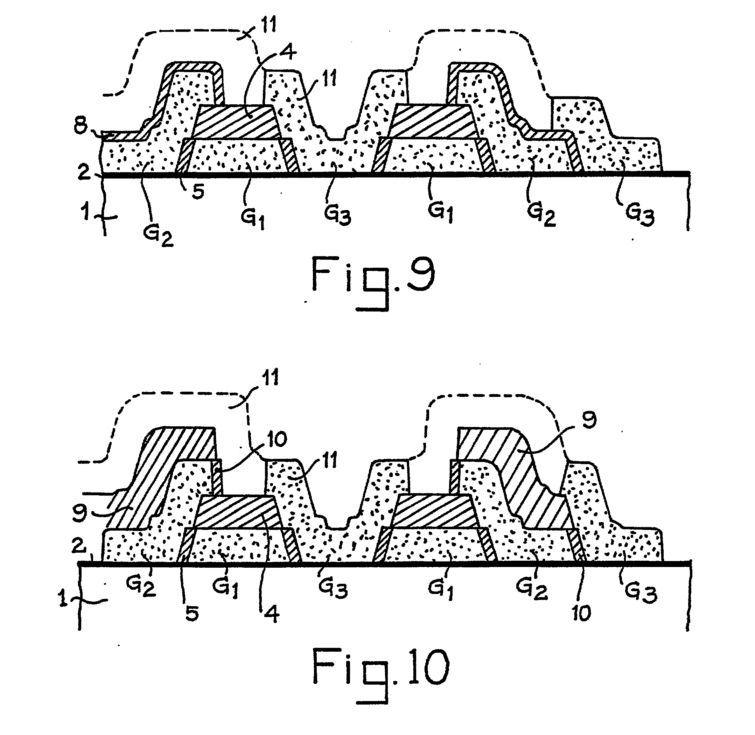

Les figures 9 et 10 illustrent les étapes qui doivent être ajoutées dans le cas de la réalisation d'un dispositif semi-conducteur à trois niveaux de grilles. Les figures 9 et 10 illustrent deux variantes du procédé selon l'invention dans le cas de trois niveaux de grilles. Il s'agit à titre d'exemple comme dans le cas des figures 1 à 8 d'un dispositif dans lequel la dissymétrie dans les potentiels de canal est réalisée par implantation ionique. Les opérations d'implantation ionique n'ont pas été représentées.

Il faut d'abord reprendre le procédé tel qu'il a été décrit précédemment.

Ensuite, on dépose une couche de diélectrique sur les grilles $G_2$ du second niveau afin de les protéger lors de la gravure des grilles du troisième niveau.

Sur la figure 9, on dépose une couche mince de diélectrique 8 sur les grilles $G_2$ après que ces grilles aient été gravées.

La couche 8 recouvre donc la totalité des parois de ces grilles. Cette couche mince 8 peut être par exemple une couche de nitrure ou d'oxyde.

Sur la figure 10, une couche de diélectrique 9 est déposée sur les grilles $G_2$ avant la gravure de ces grilles et gravée en même temps qu'elles.

Il s'agit d'une couche d'oxyde épais dont l'épaisseur est du même ordre de grandeur que celle de la couche 4. Cet oxyde épais peut être obtenu par dépôt plasma, par voie pyrolytique ou par croissance d'oxyde.

Pour protéger les parois des grilles $G_2$ qui ont été découvertes lors de leur gravure, on fait croître une couche mince d'oxyde 10 sur ces parois sensiblement verticales.

On dépose ensuite dans les modes de réalisation des figures 9 et 10 une troisième couche de matériau 11 dans lequel doivent être réalisées les grilles $G_3$ du troisième niveau.

On grave cette couche 11. Sur les figures 9 et 10, on a représenté par des pointillés les zones de la couche 11 qui ont été éliminées au cours de cette gravure.

Lorsque la gravure est terminée, on supprime la couche de diélectrique 8 ou 9 selon les figures 9 et 10 qui protège les grilles $G_2$.

Dans le mode de réalisation de la figure 9, on supprime la couche mince de diélectrique 8 qui recouvre les grilles $G_2$ partout sauf dans les zones où les grilles $G_2$ et $G_3$ sont superposées et où cette couche est indispensable pour isoler les grilles $G_2$ et $G_3$.

On ne sait pas dans le cas de la figure 9 minimiser le recouvrement entre les grilles $G_3$ et $G_2$.

Ainsi sur la partie droite de la figure 9, il n'est pas possible de minimiser le recouvrement entre les grilles $G_2$ et $G_3$ car l'intervalle entre ces grilles où se trouvait la couche mince du diélectrique 8 est très faible, de l'ordre de 1000 à 2000 Å, et ne permet pas la gravure des grilles $G_3$ par leur face interne.

Par contre dans la variante de la figure 10, on sait supprimer en même temps les couches d'oxyde épais 4 et 9, sans altérer les couches d'oxyde mince 5 et 10.

Il est donc possible d'éliminer les tronçons de grille $G_3$ surplombant les grilles $G_2$ comme cela a été expliqué dans la description des figures 1 à 5.

La variante de la figure 10 permet donc de minimiser les recouvrement entre les grilles des trois niveaux $G_1$, $G_2$ et $G_3$.

Le procédé selon l'invention dans les deux modes de réalisation décrits en se référant aux figures 9 et 10 est utilisable pour réaliser un dispositif semi-conducteur à n niveaux de grilles.

Dans le cas du mode de réalisation de la figure 9, pour obtenir n niveaux de grilles, après les étapes illustrées par les figures 1 à 5, viennent les étapes suivantes :

- on dépose une couche mince de diélectrique 8 sur les grilles du second niveau $G_2$ ;
- on dépose une troisième couche de matériau 11 dans lequel doivent être réalisées les grilles du troisième niveau $G_3$ ;
- on grave les grilles du troisième niveau ;
- et ainsi de suite on dépose une couche mince de diélectrique sur les grilles du dernier niveau déposé, puis on dépose une nouvelle couche de matériau dans lequel doivent être réalisées les grilles du niveau supérieur et on grave ces grilles ;
- une fois toutes les grilles gravées, on supprime les zones accessibles des couches minces de diélectrique 8 recouvrant les grilles, à partir des grilles du deuxième niveau $G_2$ ;
- puis, on supprime par gravure plasma ou par gravure chimique les zones des deuxièmes grilles 6, $G_2$ qui surplombent les grilles 3 du premier niveau en les attaquant simultanément par leurs faces interne et externe.

Dans le cas du mode de réalisation de la figure 10 pour obtenir n niveaux de grilles, après les étapes illustrées par les figures 1 à 4, viennent les étapes suivantes :
- on dépose une couche d'oxyde épais 9 sur les grilles du second niveau $G_2$ ;
- on grave les grilles du second niveau $G_2$ en réalisant dans ces grilles une ouverture 7 permettant d'accéder à la couche de diélectrique 4 recouvrant le dessus des grilles 3 du premier niveau ;
- on fait croître une couche mince d'oxyde sur les parois des grilles du second niveau $G_2$ qui ont été découvertes lors de la gravure de ces grilles ;
- on dépose une troisième couche de matériau 11 dans lequel doivent être réalisées les grilles du troisième niveau $G_3$ ;
- on dépose une couche d'oxyde épais sur les grilles du troisième niveau $G_3$;
- on grave les grilles du troisième niveau ;
- on fait croître une couche mince d'oxyde sur les parois des grilles du troisième niveau qui ont été découvertes lors de la gravure de ces grilles ;
- et ainsi de suite, on dépose une couche d'oxyde épais sur les grilles du dernier niveau déposé, puis on grave ces grilles, on fait croître une couche mince d'oxyde sur les parois des grilles du dernier niveau qui ont été découvertes lors de la gravure de ces grilles, et on dépose une nouvelle couche de matériau dans lequel doivent être réalisées les grilles du niveau supérieur ;
- une fois toutes les grilles gravées, on supprime les couches d'oxyde épais 4, 9 qui recouvrent ces grilles ;
- on supprime par gravure plasma ou par gravure chimique les zones des grilles qui surplombent les grilles d'un autre niveau en les attaquant simultanément par leurs faces interne et externe.

Tout ce qui a été dit en ce qui concerne la réalisation d'un dispositif à deux niveaux de grilles sur la nature des matériaux, les diverses techniques employées, etc... s'applique également à la réalisation d'un dispositif à n niveaux de grilles.

Ainsi, par exemple, les couches de matériau dans lesquelles doivent être réalisées les grilles à partir du second niveau sont en silicium polycristallin et la dernière étape est une gravure chimique réalisée après oxydation.

De même, on peut déposer une couche protectrice contre la gravure entre les grilles des divers niveaux et la couche de diélectrique qui recouvre ces grilles.

## Revendications

1. Procédé de réalisation d'un dispositif semiconducteur comportant au moins deux niveaux de grille, comprenant les étapes suivantes:

a) on dépose sur un substrat semiconducteur (1) une couche diélectrique (2), puis une couche de matériau (3) dans lequel doivent être réalisées les grilles du premier niveau, puis une couche diélectrique (4);

b) on réalise par gravure des deux couches supérieures (3 et 4) les grilles du premier niveau (G1);

c) on isole (5) les flancs des grilles (G1) du premier niveau;

d) on dépose une deuxième couche de matériau (6) dans lequel doivent être réalisées les grilles du deuxième niveau;

e) on réalise dans cette deuxième couche une ouverture (7) permettant d'accéder à la couche de diélectrique recouvrant le dessus des grilles du premier niveau,

f) on élimine, à travers l'ouverture dans la deuxième couche, la couche diélectrique recouvrant la grille du premier niveau, de manière à dénuder une portion interne de la couche du second niveau, cette portion surplombant les flancs de la grille;

g) on grave, à la fois de l'intérieur et de l'extérieur de l'ouverture (7) la couche du second niveau de manière à éliminer les dites portions surplombantes.

2. Procédé selon la revendication 1, caractérisé en ce que, entre les étapes e et f, en vue de former des niveaux de grille supplémentaires, les étapes suivantes sont intercalées:

e1) une mince couche isolante (8) est formée sur la couche de matériau du second niveau (G2), y compris sur les flancs des motifs gravés de cette couche;

e2) une couche de matériau (11) formant le troisième niveau de grille est déposée;

e3) on grave cette troisième couche (11) pour définir un motif de grilles (G3) du troisième niveau;

e4) on élimine la mince couche isolante (8) là où elle n'est plus recouverte par la troisième couche (11);

l'étape g comprenant également la gravure de portions de la couche du troisième niveau surplombant les flancs de grilles du premier ou deuxième niveau.

3. Procédé selon la revendication 1, caractérisé en ce qu'une couche isolante épaisse (9) est déposée entre les étapes d et e, cette couche étant gravée en même temps que la coche du deuxième niveau à l'étape e), puis on exécute les opérations suivantes entre l'étape e et l'étape f:

e1) une mince couche isolante (10) est formée sur les flancs gravés de la couche de matériau du second niveau (G2);

e2) une couche de matériau (11) formant le troisième niveau de grille est déposée;

e3) on grave cette troisième couche (11) pour définir un motif de grilles (G3) du troisième niveau;

e4) on élimine la mince couche isolante (10) là où elle n'est plus recouverte par la troisième couche (11);

l'étape f comprenant également l'élimination de la couche isolante épaisse (9) déposée entre les étapes d et e;

et l'étape g comprenant également la gravure de portions de la couche du troisième niveau surplombant les flancs de grilles du premier ou deuxième niveau.

4. Procédé selon l'une des revendications 1 à 3, caractérisé en ce que la gravure de l'étape g est ajustée en durée de telle sorte que sensiblement la moitié de l'épaisseur de la seconde couche soit éliminée à partir de l'extérieur de l'ouverture (7) formée dans la couche du second niveau, et sensiblement la moitié de cette épaisseur soit éliminée à partir de l'intérieur de l'ouverture.

## Claims

1. A method for realising a semiconductor device containing at least two gate levels, comprising the following steps:

a) a dielectric layer (2), then a layer of a material (3) in which the gates of the first level are to be realised, then a dielectric layer (3) are deposited on a semiconductor substrate (1),

b) the gates of the first level (G1) are realised by engraving the two upper layers (3 and 4),

c) the edges of the gates (G1) of the first level are insulated,

d) a second layer of a material (6) is deposited, in which the gates of the second level are to be realized,

e) in this second layer, an opening (7) is realised which permits access to the dielectric layer covering the surface of the gates of the first level,

f) via the opening in the second layer, the dielectric layer is eliminated, which covers the gate of the first level, so as to expose an inner portion of the layer of the second level, this portion overlapping the flancs of the gate,

g) the layer of the second level is engraved at the same time from the inside and from the outside of the opening (7), so as to eliminate said overlapping portions.

2. A method according to claim 1, characterized in that, in view of realizing supplementary gate levels, the following steps are performed between the steps e and f:

e1) a thin insulating layer (8) is realized on the layer of material of the second level (G2) and also on the flancs of the engraved patterns of this layer,

e2) a layer of material (11) forming the third gate level is deposited,

e3) this third layer (11) is engraved so as to define a gate pattern (G3) of the third level,

e4) the thin insulating layer (8) is eliminated in those places where it is no more covered by the third layer (11),

the step g equally comprising the engraving of portions of the layer of the third level overlapping the edges of the gates of the first or second level.

3. A method according to claim 1, characterized in that a thick insulating layer (9) is deposited between the steps d and e, this layer being engraved at the same time as the layer of the second level at step e), then the following operations are executed between step e and step f:

e1) a thin insulating layer (10) is formed on the engraved edges of the material layer of the second level (G2),

e2) a material layer (11) constituting the third gate level is deposited,

e3) this third layer (11) is engraved so as to define a gate pattern (G3) of the third level,

e4) the thin insulating layer (10) is eliminated in those places where it is no more covered by the third layer (11),

the step f equally comprising the elimination of the thick insulating layer (9) deposited between the steps d and e, and the step g equally comprising the engraving of portions of the layer of the third level overlapping the edges of gates of the first or second level.

4. A method according to one of claims 1 to 3, characterized in that the engraving of step g is time-adjusted in such a way that essentially half of the thickness of the second layer is eliminated from outside the opening (7) cut in the layer of the second level, and essentially half of this thickness is eliminated from inside the opening.

## Patentansprüche

1. Verfahren zur Herstellung einer Halbleitervorrichtung mit mindestens zwei Gate-Ebenen, das die folgenden Schritte aufweist:

a) man bringt eine dielektrische Schicht (2), dann eine Schicht (3) des Materials, in dem die Gates der ersten Ebene hergestellt werden sollen, und dann eine dielektrische Schicht (4) auf ein Halbleitersubstrat (1) auf,

b) man ätzt die Gates der ersten Ebene (G1) in die beiden oberen Schichten (3 und 4),

c) man isoliert (5) die Flanken der Gates (G1) der ersten Ebene,

d) man bringt eine zweite Schicht (6) des Materials auf, in dem die Gates der zweiten Ebene hergestellt werden sollen,

e) man stellt eine Öffnung (7) in dieser zweiten Schicht her, die es ermöglicht, zu der Dielektrikumsschicht Zugang zu erhalten, die die Oberseite der Gates der ersten Ebene bedeckt,

f) man entfernt durch die Öffnung in der zweiten Schicht die dielektrische Schicht, die das Gate der ersten Ebene bedeckt, um einen inneren Bereich der Schicht der zweiten Ebene freizulegen, der die Flanken des Gates überlappt,

g) man ätzt gleichzeitig von innerhalb und von außerhalb der Öffnung (7) die Schicht der zweiten Ebene, um die überlappenden Bereiche zu entfernen.

2. Verfahren nach Anspruch 1, dadurch gekennzeichnet, daß zwischen die Schritte e und f zur Bildung von zusätzlichen Gate-Ebenen die folgenden Schritte eingefügt werden:

e1) eine dünne isolierende Schicht (8) wird auf der Materialschicht der zweiten Ebene (G2) gebildet, einschließlich der Flanken der in diese Schicht geätzten Motive,

e2) eine Materialschicht (11), die die dritte Gate-Ebene bildet, wird aufgebracht,

e3) diese dritte Schicht (11) wird ausgeätzt, um ein Gatemotiv (G3) der dritten Ebene zu definieren,

e4) man entfernt die dünne isolierende Schicht (8) dort, wo sie nicht mehr von der dritten Schicht (11) bedeckt ist,

wobei der Schritt g ebenfalls das Ätzen von Bereichen der Schicht der dritten Ebene einschließt, die die Flanken der Gates der ersten oder der zweiten Ebene überlappen.

3. Verfahren nach Anspruch 1, dadurch gekennzeichnet, daß eine dicke isolierende Schicht (8) zwischen den Schritten d und e aufgebracht wird, die zur gleichen Zeit wie die Schicht der zweiten Ebene beim Schritt e) geätzt wird, und dann führt man die folgenden Arbeitsgänge zwischen dem Schritt e und dem Schritt f durch:

e1) eine dünne isolierende Schicht (10) wird auf den geätzten Flanken der Materialschicht der zweiten Ebene (G2) gebildet,

e2) eine Materialschicht (11), die die dritte Gateebene bildet, wird aufgebracht,

e3) man ätzt diese dritte Schicht (11) aus, um ein Gatemotiv (G3) der dritten Ebene zu bestimmen,

e4) man entfernt die dünne isolierende Schicht (10) dort, wo sie nicht mehr von der dritten Schicht (11) bedeckt ist,

wobei der Schritt f außerdem das Entfernen der zwischen den Schritten d und e aufgebrachten dicken isolierenden Schicht (9) einschließt,

und der Schritt g ebenfalls das Gravieren von Bereichen der Schicht der dritten Ebene, die die Flanken der Gates der ersten oder zweiten Ebene überlappen, einschließt.

4. Verfahren nach einem der Ansprüche 1 bis 3, dadurch gekennzeichnet, daß die Dauer des Ausätzens des Schritts g so eingestellt wird, daß im wesentlichen die Hälfte der Dicke der zweiten Schicht entfernt wird ausgehend von der Außenseite der in der Schicht der zweiten Ebene gebildeten Öffnung (7) und im wesentlichen die Hälfte dieser Dicke ausgehend von der Innenseite dieser Öffnung entfernt wird.

EP 0 209 425 B1

Fig.1

Fig.2

Fig.3

Fig.4

Fig.5

Fig.6

Fig.7

Fig.8

Fig.9

Fig.10